(19) Europäisches Patentamt
European Patent Office
Office européen des brevets

(11) **EP 2 463 924 B1**

(12) **FASCICULE DE BREVET EUROPEEN**

(45) Date de publication et mention
de la délivrance du brevet:
**10.07.2013 Bulletin 2013/28**

(51) Int Cl.:
*H01L 35/16* *(2006.01)*       *H01L 35/34* *(2006.01)*
*B41M 5/00* *(2006.01)*       *B41M 7/00* *(2006.01)*

(21) Numéro de dépôt: **11354075.1**

(22) Date de dépôt: **08.12.2011**

(54) **Dépôt de matériaux thermoélectriques par impression**

Aufbringung von thermoelektrischem Material durch Druck

Deposition of thermoelectric materials by stamping

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.12.2010 FR 1004815**

(43) Date de publication de la demande:
**13.06.2012 Bulletin 2012/24**

(73) Titulaire: **Commissariat à l'Énergie Atomique et aux Énergies Alternatives
75015 Paris (FR)**

(72) Inventeurs:
• **Navone, Christelle**
**38430 Saint Jean de Moirans (FR)**
• **Soulier, Mathieu**
**38130 Echirolles (FR)**

(74) Mandataire: **Talbot, Alexandre et al
Cabinet Hecké
Europole
10, rue d'Arménie - BP 1537
38025 Grenoble Cedex 1 (FR)**

(56) Documents cités:
WO-A1-99/65086        JP-A- 10 098 216
JP-A- 2006 040 963     JP-A- 2010 040 998
US-A- 3 554 815        US-A- 4 902 648

• C. NAVONE ET AL: "Optimization and Fabrication of a Thick Printed Thermoelectric Device", JOURNAL OF ELECTRONIC MATERIALS, vol. 40, no. 5, 1 mai 2011 (2011-05-01), pages 789-793, XP055002574, ISSN: 0361-5235, DOI: 10.1007/s11664-011-1572-6
• C. NAVONE ET AL: "Development of (Bi,Sb)2(Te, Se)3-Based Thermoelectric Modules by a Screen-Printing Process", JOURNAL OF ELECTRONIC MATERIALS, vol. 39, no. 9, 1 septembre 2010 (2010-09-01), pages 1755-1759, XP055002557, ISSN: 0361-5235, DOI: 10.1007/s11664-010-1187-3

EP 2 463 924 B1

## Description

### Domaine technique de l'invention

L'invention est relative à la réalisation de modules thermoélectriques, et plus particulièrement au dépôt de couches en matériau thermoélectrique par impression.

### État de la technique

Un module thermoélectrique comprend plusieurs éléments thermoélectriques, appelés également thermoéléments, connectés électriquement en série et thermiquement en parallèle. Les performances d'un tel module dépendent des matériaux thermoélectriques utilisés et de sa géométrie.

On choisit généralement les matériaux thermoélectriques ayant un facteur de mérite ZT élevé à la température de fonctionnement du module. Le facteur de mérite s'écrit :

$$ZT = \frac{\sigma \cdot S^2}{\lambda} T,$$

où $\sigma$ est la conductivité électrique, S est le coefficient Seebeck, $\lambda$ la conductivité thermique et T la température. Le produit $\sigma \cdot S^2$ est appelé facteur de puissance.

Un matériau avec de bonnes propriétés thermoélectriques présente donc idéalement une conductivité électrique et un coefficient Seebeck élevés, ainsi qu'une faible conductivité thermique. A température ambiante, les alliages à base de bismuth (Bi) et de tellure (Te) sont particulièrement intéressants.

La géométrie du module est optimisée pour chaque application en fonction de l'environnement d'utilisation du module, c'est-à-dire en fonction des conditions thermiques. En particulier, l'épaisseur optimale des thermoéléments dépend principalement des matériaux choisis, de la conductivité thermique du module et du flux thermique fourni par la source chaude.

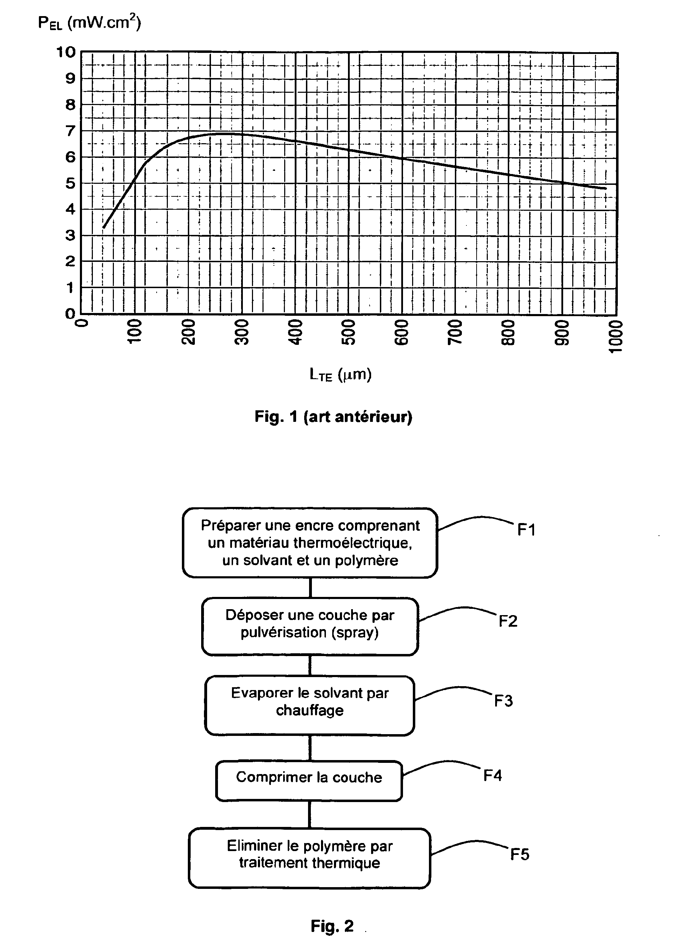

La figure 1 représente la puissance électrique générée par un module en fonction de l'épaisseur de ses thermoéléments, pour un flux de chaleur donné (5 W.cm$^{-2}$). Dans cet exemple, l'épaisseur optimale est de l'ordre de 300 $\mu$m. Pour des flux modérés (inférieurs à 10 W.cm$^{-2}$), on constate que la puissance électrique générée est maximale pour des épaisseurs comprises entre 50 $\mu$m et 500 $\mu$m.

Il existe plusieurs technologies pour réaliser des thermoéléments. On distingue notamment la formation de thermoéléments en couches minces, par des procédés de dépôt empruntés de la microélectronique, et la fabrication d'éléments massifs (« Bulk » en anglais) par des techniques de frittage, de découpe et d'assemblage.

Les procédés de dépôt en couches minces, de type PVD ou CVD, sont mal adaptés à la formation de couches d'épaisseur supérieure à 50 $\mu$m. La technologie « bulk » requiert un haut niveau de précision et de contrôle de qualité pour réaliser des thermoéléments d'épaisseur inférieure à 500 $\mu$m. Cette technologie, lourde à mettre en oeuvre, devient alors difficilement applicable à grande échelle.

Pour réaliser des thermoéléments d'une épaisseur comprise entre 50 $\mu$m et 500 $\mu$m de façon simple et reproductible, on fait appel à des techniques d'impression, notamment l'impression jet d'encre et la sérigraphie.

L'article [Development of (Bi,Sb)2(Te,Se)3-Based Thermoelectric Modules by a Screen-Printing Process, Navone et al., Journal of Electronic Materials, Vol. 39, N° 9, 2010] décrit la réalisation de thermoéléments par sérigraphie.

Dans un premier temps, une encre est préparée en mélangeant une poudre de matériaux actifs, un polymère liant et un solvant. La poudre contient des particules de matériaux semi-conducteurs : tellure (Te), bismuth (Bi), antimoine (Sb) et sélénium (Se). La quantité de matériaux actifs représente 76 % de la masse de l'encre. Le polystyrène est choisi en tant que polymère liant et représente 2 % de la masse de l'encre. La quantité restante correspond au solvant : le toluène.

L'encre est ensuite déposée par sérigraphie sur un substrat flexible en polyéthylène naphtalate (PEN) selon des plots de 80 $\mu$m d'épaisseur. Le solvant est ensuite évaporé en élevant la température à 60°C pendant plusieurs heures. Une pression uni-axiale de 50 MPa est appliquée sur les plots pour augmenter la cohésion des particules et l'adhésion des plots sur le substrat PEN. Enfin, un recuit par laser pulsé, d'une puissance de 473 mJ.cm-2, est réalisé pour éliminer le polymère et ainsi augmenter la conductivité électrique des thermoéléments.

On observe cependant des contraintes mécaniques importantes dans la couche thermoélectrique réalisée selon cette technique. En effet, lors des étapes de traitement thermique, l'évaporation du solvant et l'élimination du polymère provoquent des mouvements de grains dans la couche. Des fissures peuvent apparaître dans les thermoéléments. Les thermoéléments sont, en outre, sensibles au phénomène de délamination sur certains substrats.

**Résumé de l'invention**

On constate qu'il existe un besoin de prévoir un procédé de réalisation d'une couche en matériau thermoélectrique ayant à la fois de bonnes propriétés mécaniques et des performances thermoélectriques élevées.

On tend à satisfaire ce besoin en préparant une encre comprenant le matériau thermoélectrique, un solvant et un matériau polymère liant, en déposant une couche d'encre sur un substrat, en chauffant la couche d'encre pour évaporer le solvant, en comprimant la couche et en réalisant un traitement thermique pour éliminer le matériau polymère liant. Le dépôt de la couche d'encre est réalisé par pulvérisation sous pression sous des conditions telles que le solvant soit partiellement évaporé avant d'atteindre le substrat.

**Description sommaire des dessins**

D'autres avantages et caractéristiques ressortiront plus clairement de la description qui va suivre de modes particuliers de réalisation donnés à titre d'exemples non limitatifs et illustrés à l'aide des dessins annexés, dans lesquels :

- la figure 1, précédemment décrite, représente la puissance électrique générée par un module thermoélectrique en fonction de l'épaisseur des thermoéléments ;

- la figure 2 est un organigramme illustrant un procédé de réalisation de couches en matériau thermoélectrique selon l'invention ; et,

- les figures 3 et 4 sont respectivement des prises de vue au microscope d'une couche thermoélectrique obtenue par sérigraphie et d'une couche obtenue par le procédé selon l'invention.

**Description d'un mode de réalisation préféré de l'invention**

On propose ici de limiter les contraintes internes dues à l'élimination du solvant et du matériau polymère en déposant l'encre par pulvérisation. Les conditions de pulvérisation sont choisies de manière qu'une partie du solvant soit évaporée lors du dépôt. On obtient alors une couche poreuse, qui va permettre la relaxation des contraintes lors de l'élimination finale des additifs.

La figure 2 représente, sous forme d'organigramme, des étapes d'un procédé de réalisation de couches en matériau thermoélectrique aux contraintes relâchées.

Dans une étape F1, on prépare une encre compatible avec la technique d'impression par pulvérisation. L'encre comprend un matériau thermoélectrique destiné à former les thermoéléments, un matériau polymère et un solvant.

Le matériau thermoélectrique est, de préférence, sous forme de particules semi-métalliques ou semi-conductrices, de diamètre compris entre 10 nm et 10 $\mu$m, dispersées dans le solvant. Le matériau thermoélectrique peut être choisi parmi les alliages de bismuth et tellure, par exemple une poudre de $Bi_{0,5}Sb_{1,5}Te_3$ pour des thermoéléments de type P et une poudre de $Bi_2Te_{2,7}Se_{0,3}$ pour des thermoéléments de type N.

Le solvant est choisi de manière qu'il s'évapore partiellement lors de l'impression par pulvérisation, c'est-à-dire avant d'atteindre le substrat. En outre, on privilégie un solvant ayant une mouillabilité élevée par rapport au matériau thermoélectrique. Cela signifie que la tension de surface du solvant est supérieure à celle du matériau thermoélectrique. Un tel solvant est, de préférence, choisi parmi le toluène, le polyglycolméthylétheracétate (PGMEA), le tétrahydrofurène (THF) et le dichlorométhane.

Le matériau polymère est dissout dans le solvant. Il joue le rôle de liant entre les particules thermoélectriques et favorise l'adhésion de l'encre sur le substrat. Le polymère est, de préférence, du polystyrène.

L'encre est majoritairement constituée de particules thermoélectriques. Une forte concentration en particules thermoélectriques augmente la conductivité électrique des thermoéléments, ce qui améliore le facteur de mérite ZT. En contrepartie, l'encre est plus visqueuse. Une quantité de polymère élevée favorise la cohésion des particules mais détériore les propriétés thermoélectriques, notamment le coefficient Seebeck. De préférence, l'encre comprend, en pourcentage de sa masse, entre 62 % et 74 % de matériau thermoélectrique, entre 1 % et 3 % de polymère et entre 25 % et 35 % de solvant.

L'encre pourra également comprendre un dispersant afin d'homogénéiser la constitution de l'encre, par exemple le dispersant commercialisé sous la marque Triton par la société Union Carbide Corporation.

A l'étape F2, on dépose une couche d'encre d'épaisseur comprise entre 60 $\mu$m et 1500 $\mu$m sur un substrat par pulvérisation sous pression (« Pressurized Spray deposition» en anglais, PSD). Un gaz comprimé, inerte vis-à-vis des constituants de l'encre, provoque l'éjection de gouttelettes depuis une buse d'impression, sous la forme d'un spray. La viscosité de l'encre, le diamètre de la buse et la pression du gaz détermine la vitesse à laquelle sont éjectées les gouttelettes. L'utilisation d'un masque en contact avec le substrat permet, le cas échéant, de définir des motifs dans la couche imprimée.

Les conditions opératoires sont choisies pour que la totalité du solvant ne soit pas évaporée lors de la pulvérisation. En effet, lorsque le solvant est entièrement évaporé, la couche imprimée présente un aspect poudreux sans aucune adhérence sur le substrat. Les conditions de pulvérisation sont, de préférence, choisies de manière à évaporer entre 70 % et 90 % de la quantité de solvant.

Grâce à la forte mouillabilité du solvant, la répartition des gouttelettes au sein du spray est globalement homogène. La qualité du dépôt est alors améliorée. En outre, cela permet d'éviter la formation d'agrégats volumineux entre les particules, qui risqueraient d'obturer la buse d'impression.

Le dépôt par pulvérisation peut être entièrement automatisé et assisté par des ultrasons (ultrasonic spray deposition, USD). Des vibrations hautes fréquences divisent l'encre en gouttelettes plus fines, qui sont ensuite portées par le gaz jusqu'au substrat.

Les paramètres opératoires suivants ont permis d'obtenir des résultats satisfaisants :

- distance buse-substrat comprise entre 5 cm et 10 cm ;

- diamètre de la buse supérieur à 40 fois la taille des particules (> 400 $\mu$m) ;

- pression du gaz comprimé (azote, argon ou air) servant à la pulvérisation comprise entre $0,8.10^5$ Pa et $10^5$ Pa ;

L'encre est, de préférence, chauffée à une température strictement inférieure à la température d'ébullition du solvant pendant l'étape de pulvérisation. L'évaporation partielle du solvant peut, par exemple, se faire à température ambiante dans le cas du toluène (Température d'ébullition du toluène : 110 °C). Pour d'autres solvants à température d'ébullition plus élevée, il est préférable de chauffer le spray d'encre, par exemple entre 80 °C et 100 °C dans le cas du PGMEA ($T_{ébul}$ = 146 °C).

Le chauffage de l'encre lors de la pulvérisation peut être réalisé par convection à partir du chauffage du substrat. Dans le cas du PGMEA et d'une distance buse-substrat de 5 cm à 10 cm, le substrat peut être chauffé à une température comprise entre 90 °C et 120 °C. Pour le toluène, le substrat peut aussi être légèrement chauffé, entre 20 °C et 50 °C.

Lors d'une étape F3, la quantité restante de solvant est évaporée par chauffage. La structure poreuse de la couche obtenue par pulvérisation favorise l'évaporation finale du solvant. Les mouvements de grains sont moins importants, ce qui rend la couche plus résistante mécaniquement. On peut ainsi augmenter la température de chauffage sans risque de fragiliser la couche. La température de séchage est, de préférence, comprise entre 90 °C et 150 °C.

Compte tenu qu'une partie du solvant est déjà évaporée et grâce à une température plus élevée, la durée du chauffage peut être considérablement réduite par rapport aux techniques classiques. La durée du chauffage peut être de quelques minutes.

Après évaporation complète du solvant, la quantité de polymère représente environ 2 % de l'extrait sec et la quantité de matériaux thermoélectriques représente environ 98 % de l'extrait sec.

Cet extrait sec peut aussi contenir de 1 % à 3 % d'additifs visant à améliorer les performances thermoélectriques. Cela peut être des nanoparticules métalliques, des nanotubes de carbone, des impuretés comme des halogénures (AgI) ou des oxydes métalliques.

A une étape F4, la couche est comprimée selon une direction perpendiculaire au substrat. La pression exercée varie, de préférence, entre 50 MPa et 200 MPa en fonction de l'épaisseur de la couche. Les pressions les plus élevées sont appliquées aux couches de faible épaisseur (50-100 $\mu$m).

A une étape F5, un traitement thermique est réalisé pour éliminer le matériau polymère. Ce traitement thermique est, de préférence, réalisé sous atmosphère inerte à une température comprise entre 350 °C et 400 °C dans le cas d'alliages à base de bismuth et de tellure.

L'étape de compression (F4), suivie d'un recuit (F5) à une température de l'ordre de 80 % de la température de fusion du matériau thermoélectrique, correspond à une opération de frittage. Elle permet d'augmenter la densité de la couche. Ainsi, on améliore les propriétés thermoélectriques, en particulier la conductivité électrique.

Grâce aux meilleures propriétés mécaniques de la couche obtenues aux étapes précédentes, la pression de frittage peut être augmentée par rapport aux techniques de l'art antérieur. Cela permet d'atteindre des conductivités électriques plus élevées.

Dans le cas d'un substrat flexible, par exemple en polyimide, il est généralement plus difficile d'obtenir une couche thermoélectrique de qualité et qui adhère sur le substrat. En effet, le coefficient de dilation du polyimide étant largement supérieur à celui des matériaux thermoélectriques, la couche imprimée sur le substrat polyimide est contrainte en tension. Cette contrainte en tension est plus faible pour les autres types de substrat, par exemple en verre (quartz), car la différence de coefficients de dilation est moins importante.

Le procédé décrit ci-dessus est particulièrement bien adapté aux substrats en matière plastique, en polyimide notamment. Il garantit l'adhésion des couches thermoélectriques sur le polyimide.

A titre d'exemple, des thermoéléments de type P et N sont réalisés sur un substrat flexible en polyimide à l'aide du procédé de la figure 2. Les thermoéléments de type P, de 60 $\mu$m d'épaisseur environ, sont en alliage $Bi_{0,5}Sb_{1,5}Te_3$. L'étape de frittage des thermoéléments de type P est constituée d'une compression uniaxiale à 50 MPa suivi d'un recuit à 396 °C pendant 6 heures sous argon. Les thermoéléments de type N, d'environ 80 $\mu$m d'épaisseur en alliage $Bi_2Te_{2,7}Se_{0,3}$, sont soumis à une pression de l'ordre de 200 MPa. Le recuit est identique à celui des thermoéléments de type P.

**Tableau 1**

| Type de matériau | Type P | | Type N | |
|---|---|---|---|---|
| | Avant frittage | Après frittage | Avant frittage | Après frittage |
| $\sigma$ (S.m$^{-1}$) | 190 | 80000 | 115 | 13000 |
| S ($\mu$V.K$^{-1}$) | 164 | 74 | -99 | -224 |

Le tableau 1 ci-dessus donne les caractéristiques thermoélectriques (conductivité électrique $\sigma$ et coefficient Seebeck S) des thermoéléments, mesurées avant et après frittage.

Avant l'étape de frittage, le facteur de puissance $\sigma.S^2$ vaut $5,1.10^{-2}$ $\mu$W.cm$^{-1}$.K$^{-1}$ pour les thermoéléments de type P et $5,88.10^{-5}$ $\mu$W.cm$^{-1}$.K$^{-1}$ pour les thermoéléments de type N.

Après l'étape de frittage, le facteur de puissance vaut respectivement 4,38 $\mu$W.cm$^{-1}$.K$^{-1}$ et 6,50 $\mu$W.cm$^{-1}$.K$^{-1}$ pour les thermoéléments de type P et de type N. Le facteur de puissance est donc augmenté considérablement grâce à l'étape de frittage, en particulier dans le cas des thermoéléments de type N soumis à une pression de 200 MPa.

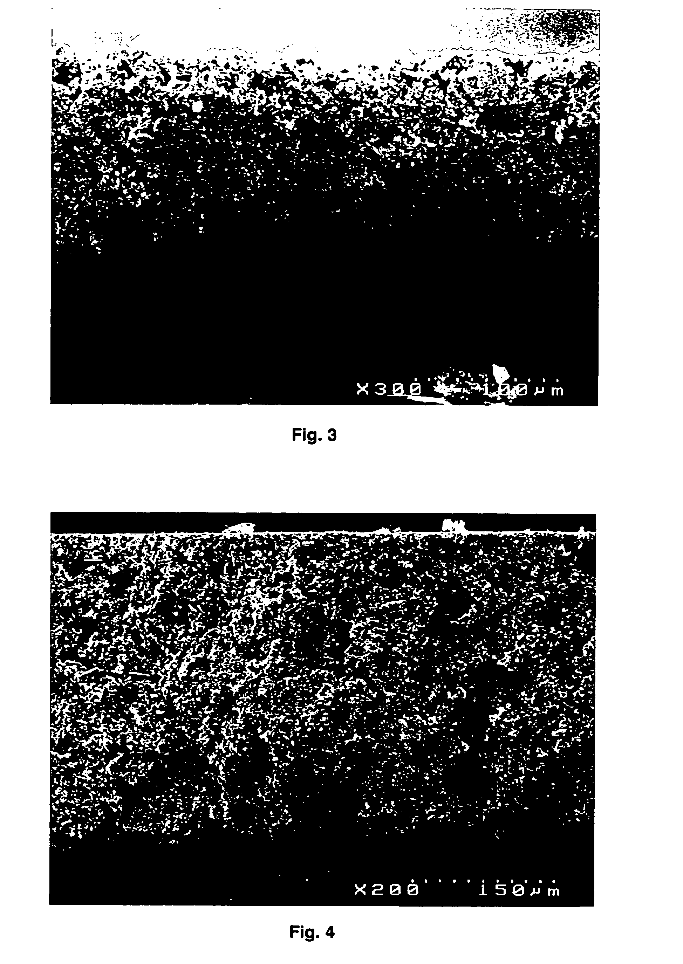

Les figures 3 et 4 montrent respectivement une couche thermoélectrique de 60 $\mu$m d'épaisseur obtenue par sérigraphie et une couche de même épaisseur obtenue par pulvérisation.

Les couches ont été observées au microscope électronique à balayage après l'étape de frittage. La couche obtenue par sérigraphie (Fig.3) n'ayant pas adhérée sur le substrat en polyimide, elle a été retournée et collée sur un autre substrat pour être observée. La portion de la couche en contact avec le substrat en polyimide se retrouve donc en haut sur la figure 3.

On constate dans la couche imprimée par sérigraphie la présence de cavités ou de fissures. Ces défauts proviennent de l'évaporation du solvant pendant l'étape de chauffage. De plus, la couche présente une densité variable suivant l'épaisseur de la couche. La portion supérieure (en contact avec le polyimide) est moins dense que le reste de la couche. Cette faible densité empêche l'adhésion sur le substrat en polyimide.

En revanche, on observe que la couche déposée par spray est dépourvue de défauts structurels, par exemple de fissures, et que la densité de la couche est globalement homogène. Les thermoéléments ainsi formés adhèrent parfaitement au substrat en polyimide.

La technique d'impression par pulvérisation permet donc d'obtenir, sous certaines conditions, un module fiable et performant, avec des couches thermoélectriques d'épaisseur optimisée. Même si les performances obtenues restent inférieures à celles des thermoéléments fabriqués en technologie « Bulk » (de 35 $\mu$W.cm$^{-1}$.K$^{-1}$ à 40 $\mu$W.cm$^{-1}$.K$^{-1}$ pour les mêmes matériaux), elles se révèlent être particulièrement intéressantes en considérant les aspects coût et simplicité du procédé mis en oeuvre.

De nombreuses variantes et modifications du procédé de réalisation de couches thermoélectriques apparaîtront à l'homme du métier. En particulier, d'autres matériaux thermoélectriques pourront être utilisés, notamment $Zn_4Sb_3$. On pourra également envisager le dépôt de couches dans des cavités formées dans un substrat plutôt que sur un support plan, afin de réaliser des modules tridimensionnels.

**Revendications**

1.  Procédé de réalisation d'une couche en matériau thermoélectrique d'une épaisseur comprise entre 50 $\mu$m et 500 $\mu$m sur un substrat, comprenant les étapes suivantes :

    - préparer une encre comprenant le matériau thermoélectrique, un matériau polymère liant et un solvant ;
    - déposer une couche d'encre sur le substrat ;
    - chauffer la couche d'encre pour évaporer le solvant ;
    - comprimer la couche ; et
    - réaliser un traitement thermique pour éliminer le matériau polymère liant ;

**caractérisé en ce que** le dépôt de la couche d'encre est réalisé par pulvérisation sous pression sous des conditions telles que le solvant soit partiellement évaporé avant d'atteindre le substrat.

2. Procédé selon la revendication 1, **caractérisé en ce que** les conditions sont telles que la quantité de solvant évaporée lors du dépôt de la couche d'encre est comprise entre 70 % et 90 %.

3. Procédé selon la revendication 1 ou 2, **caractérisé en ce que** l'encre comprend du toluène ou du polyglycolméthylétheracétate dans lequel sont dispersées des particules de matériau thermoélectrique ayant un diamètre compris entre 10 nm et 10 $\mu$m et dans lequel est dissout du polystyrène.

4. Procédé selon l'une quelconque des revendications 1 à 3, **caractérisé en ce que** le pourcentage massique de matériau thermoélectrique dans l'encre est compris entre 62 % et 74 %, **en ce que** le pourcentage massique de polymère est compris entre 1 % et 3 % et **en ce que** le pourcentage massique de solvant est compris entre 25 % et 35 %.

5. Procédé selon l'une quelconque des revendications 1 à 4, **caractérisé en ce que** l'encre est chauffée à une température strictement inférieure à la température d'ébullition du solvant pendant l'étape de dépôt de la couche d'encre.

6. Procédé selon la revendication 5, **caractérisé en ce que** le substrat est chauffé pendant l'étape de dépôt de la couche d'encre.

7. Procédé selon la revendication 6, **caractérisé en ce que**, le solvant étant du toluène, le substrat est chauffé à une température comprise entre 20 °C et 50 °C.

8. Procédé selon la revendication 6, **caractérisé en ce que**, le solvant étant du polyglycolméthylétheracétate, le substrat est chauffé à une température comprise entre 90 °C et 120 °C.

9. Procédé selon l'une quelconque des revendications 1 à 8, caractérisé en que l'encre est projetée sur le substrat par une buse de diamètre supérieur à 400 $\mu$m, disposée à une distance du substrat comprise entre 5 cm et 10 cm, à l'aide d'un gaz sous une pression comprise entre $0,8.10^5$ Pa et $10^5$ Pa.

10. Procédé selon l'une quelconque des revendications 1 à 9, **caractérisé en ce que** la couche d'encre est chauffée à une température comprise entre 90 °C et 150 °C.

11. Procédé selon l'une quelconque des revendications 1 à 10, **caractérisé en ce que** la couche est comprimée à une pression comprise entre 50 MPa et 200 MPa.

12. Procédé selon l'une quelconque des revendications 1 à 11, **caractérisé en ce que**, le matériau thermoélectrique étant un alliage à base de bismuth et de tellure, le traitement thermique est réalisé à une température comprise entre 350 °C et 400 °C.

13. Procédé selon l'une quelconque des revendications 1 à 12, **caractérisé en ce que** le substrat est en polyimide.

14. Procédé selon l'une quelconque des revendications 1 à 13, **caractérisé en ce que** le dépôt de la couche d'encre est assisté par ultrasons.

**Patentansprüche**

1. Verfahren zum Realisieren einer thermoelektrischen Materialschicht mit einer Dicke zwischen 50 $\mu$m und 500 $\mu$m auf einem Substrat, mit den folgenden Schritten:

- Herstellen einer Tinte, die das thermoelektrische Material, ein polymeres Bindemterial und ein Lösungsmittel enthält;
- Aufbringen einer Tintenschicht auf das Substrat;
- Erhitzen der Tintenschicht, um das Lösungsmittel zu verdampfen;
- Komprimieren der Schicht; sowie

- Durchführen einer Wärmebehandlung, um das polymere Bindematerial zu entfernen;

**dadurch gekennzeichnet, dass** das Aufbringen der Farbschicht durch Zerstäubung unter Druck unter Bedingungen durchgeführt wird, die derart sind, dass das Lösungsmittel vor Erreichen des Substrats teilweise verdampft ist.

2. Verfahren gemäß Anspruch 1, **dadurch gekennzeichnet, dass** die Bedingungen derart sind, dass die Menge des während der Aufbringung der Tintenschicht verdampften Lösungsmittels zwischen 70 % und 90 % beträgt.

3. Verfahren gemäß Anspruch 1 oder 2, **dadurch gekennzeichnet, dass** die Tinte Toluol oder Polyglykol-Methylätherazetat enthält, in dem Partikel des thermoelektrischen Materials mit einem Durchmesser zwischen 10 nm und 10 μm dispergiert sind und in dem Polystyrol aufgelöst ist.

4. Verfahren gemäß einem der Ansprüche 1 bis 3, **dadurch gekennzeichnet, dass** der Massenanteil des thermoelektrischen Materials in der Tinte zwischen 62 % und 74 % liegt, dass der Massenanteil des Polymers zwischen 1 % und 3% liegt und dass der Massenanteil des Lösungsmittels zwischen 25 % und 35 % liegt.

5. Verfahren gemäß einem der Ansprüche 1 bis 4, **dadurch gekennzeichnet, dass** die Tinte während des Schrittes des Aufbringens der Tintenschicht auf eine Temperatur erhitzt wird, die genau unter der Siedetemperatur des Lösungsmittels liegt

6. Verfahren gemäß Anspruch 5, **dadurch gekennzeichnet, dass** das Substrat während des Schrittes des Aufbringens der Tintenschicht erhitzt wird.

7. Verfahren gemäß Anspruch 6, **dadurch gekennzeichnet, dass**, wenn das Lösungsmittel aus Toluol besteht, das Substrat auf eine Temperatur zwischen 20 °C und 50 °C erhitzt wird.

8. Verfahren gemäß Anspruch 6, **dadurch gekennzeichnet, dass**, wenn das Lösungsmittel aus Polyglykol-Methylätherazetat besteht, das Substrat auf eine Temperatur zwischen 90 °C und 120 °C erhitzt wird.

9. Verfahren gemäß einem der Ansprüche 1 bis 8, **dadurch gekennzeichnet, dass** die Tinte durch eine Düse mit einem Durchmesser von mehr als 400 μm mithilfe eines Gases unter einem Druck von $0,8.10^5$ Pa bis $10^5$ Pa auf das Substrat aufgespritzt wird, wobei die Düse in einer Entfernung von dem Substrat zwischen 5 cm und 10 cm angeordnet ist.

10. Verfahren gemäß einem der Ansprüche 1 bis 9, **dadurch gekennzeichnet, dass** die Tintenschicht auf eine Temperatur zwischen 90 °C und 150 °C erhitzt wird.

11. Verfahren gemäß einem der Ansprüche 1 bis 10, **dadurch gekennzeichnet, dass** die Schicht mit einem Druck zwischen 50 MPa und 200 MPa komprimiert wird.

12. Verfahren gemäß einem der Ansprüche 1 bis 11, **dadurch gekennzeichnet, dass**, wenn das thermoelektrische Material aus einer Legierung auf der Basis von Bismut und Tellur besteht, die Wärmebehandlung bei einer Temperatur zwischen 350 °C und 400 °C durchgeführt wird.

13. Verfahren gemäß einem der Ansprüche 1 bis 12, **dadurch gekennzeichnet, dass** das Substrat aus Polyimid besteht.

14. Verfahren gemäß einem der Ansprüche 1 bis 13, **dadurch gekennzeichnet, dass** die Aufbringung der Tintenschicht durch Ultraschallwellen unterstützt wird.

**Claims**

1. Method for producing a layer of thermoelectric material having a thickness comprised between 50 μm and 500 μm on a substrate, comprising the following steps :

    - preparing an ink comprising the thermoelectric material, a binding polymer material and a solvent ;
    - depositing a layer of ink on the substrate ;
    - heating the layer of ink to evaporate the solvent ;

- compressing the layer; and
- performing heat treatment to eliminate the binding polymer material ;

**characterized in that** deposition of the layer of ink is achieved by pressurized spraying under conditions such that the solvent is partially evaporated before reaching the substrate.

2. Method according to claim 1, **characterized in that** the conditions are such that the quantity of solvent evaporated when deposition of the layer of ink is performed is comprised between 70 % and 90 %.

3. Method according to claim 1 or 2, **characterized in that** the ink comprises toluene or polyglycol-methyl-ether acetate, in which particles of thermoelectric material having a diameter comprised between 10 nm and 10 $\mu$m are dispersed, and in which polystyrene is dissolved.

4. Method according to any one of claims 1 to 3, **characterized in that** the weight percentage of thermoelectric material in the ink is comprised between 62 % and 74 %, **in that** the weight percentage of polymer is comprised between 1 % and 3 % and **in that** the weight percentage of solvent is comprised between 25 % and 35 %.

5. Method according to any one of claims 1 to 4, **characterized in that** the ink is heated to a temperature strictly lower than the boiling temperature of the solvent during deposition of the layer of ink.

6. Method according to claim 5, **characterized in that** the substrate is heated during deposition of the layer of ink.

7. Method according to claim 6, **characterized in that**, the solvent being toluene, the substrate is heated to a temperature comprised between 20 °C and 50 °C.

8. Method according to claim 6, **characterized in that**, the solvent being polyglycol-methyl-ether acetate, the substrate is heated to a temperature comprised between 90 °C and 120 °C.

9. Method according to any one of claims 1 to 8, **characterized in that** the ink is projected onto the substrate by a nozzle with a diameter of more than 400 $\mu$m, located at a distance from the substrate comprised between 5 cm and 10 cm by means of a gas under a pressure comprised between $0,8,10^5$ Pa and $10^5$ Pa.

10. Method according to any one of claims 1 to 9, **characterized in that** the layer of ink is heated to a temperature comprised between 90 °C and 150 °C.

11. Method according to any one of claims 1 to 10, **characterized in that** the layer is compressed at a pressure comprised between 50 MPa and 200 MPa.

12. Method according to any one of claims 1 to 11, **characterized in that**, the thermoelectric material being a bismuth and tellurium based alloy, the heat treatment is performed at a temperature comprised between 350 °C and 400 °C.

13. Method according to any one of claims 1 to 12, **characterized in that** the substrate is made from polyimide.

14. Method according to any one of claims 1 to 13, **characterized in that** deposition of the layer of ink is performed by ultrasonic-assisted deposition.

$P_{EL}$ (mW.cm$^2$)

$L_{TE}$ ($\mu$m)

**Fig. 1 (art antérieur)**

| | |
|---|---|
| Préparer une encre comprenant un matériau thermoélectrique, un solvant et un polymère | F1 |
| Déposer une couche par pulvérisation (spray) | F2 |
| Evaporer le solvant par chauffage | F3 |
| Comprimer la couche | F4 |
| Eliminer le polymère par traitement thermique | F5 |

**Fig. 2**

Fig. 3

Fig. 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **NAVONE et al.** Development of (Bi,Sb)2(Te,Se)3-Based Thermoelectric Modules by a Screen-Printing Process. *Journal of Electronic Materials,* 2010, vol. 39 (9